# EUROPEAN PATENT APPLICATION

(11) **EP 4 838 745 A1**
(43) Date of publication of application: **11.11.2026**
(21) Application number: 25174359.7
(22) Date of filing: 06.05.2025
(51) Int. Cl.: H02J 7/00, G01R 31/389, H01M 10/48

(54) **METHOD OF DETECTING ABUSE OF A RECHARGEABLE LI-ION OR NA-ION CELL**

(71) Applicant: CSEM Centre Suisse d'Electronique et de Microtechnique SA - Recherche et Développement, 2002 Neuchâtel (CH)
(72) Inventor: BHOIR, Shubham, 2056 Dombresson (CH)
(74) Representative: Patentsmith SA

(57) **Abstract**

Method of detecting abuse of a rechargeable lithium-ion or sodium-ion cell (1), comprising steps of:
- carrying out electrochemical impedance spectroscopy measurements on said cell (1), at least at a characteristic frequency *f** having a correlation with an internal temperature of said cell (1);
- measuring an impedance Z of said cell (1) at said characteristic frequency f*, said impedance having a measured real component *Re*(*Z*)*ₘ*, a measured imaginary component *Im*(*Z*)*ₘ* and a measured phase angle *φ*(*Z*);
- estimating an estimated real component *Re*(*Z*)*ₑ* of said impedance Z on the basis of a predetermined correlation with said measured phase angle *φ*(*Z*);
- detecting said abuse on the basis of a difference between said measured real component of said impedance *Re*(*Z*)*ₘ* and said estimated real component of said impedance *Re*(*Z*)*ₑ* exceeding a predetermined threshold value.

## Description

### Technical Field

The present invention relates to the field of rechargeable batteries. More particularly, it relates to a method of detecting abuse of a rechargeable lithium-ion or sodium-ion cell, such as overheating, overcharging or mechanical abuse.

### State of the Art

With the mass uptake of rechargeable lithium-ion and sodium-ion batteries in everyday devices, vehicles, home electrical storage etc., battery fires have become more commonplace.

Such batteries are complex chemical systems that must be operated within the boundaries specified by the manufacturer. Usage outside these limits is termed "abuse" of the battery, and can lead to an increase in internal temperature, ultimately leading to thermal runaway (TR) of the battery and a battery fire. Such types of abuse are classified as:
- thermal abuse, when the battery is operated outside its mandated temperature limits. This can occur due to external temperature influences (i.e. external heating), or internal processes in the battery itself;
- electrical abuse, such as overcharging, over-discharging, internal or external short-circuits.
- mechanical abuse, such as deformation of the battery itself;

Temperature measurement of the battery is one of the most direct methods of predicting that a potential TR may occur. However, integrating a temperature sensor on each cell of the battery pack can be costly, and subject to a non-trivial engineering optimization. Moreover, these sensors will measure only the temperature at the surface of the battery, but the internal temperature may be quite different, depending on the size and shape of the cell. Furthermore, the time lag between an increase in internal cell temperature and its detection by a sensor mounted on the cell surface may be sufficiently long so as to prevent sufficiently-timely detection of a TR. Integration of internal temperature sensors is complex, bulky, and may interfere with the functioning of the cell. Also, integration of cells within or on the surface of every individual cell in a battery pack increases the number of electrical connections significantly.

Hence, various methodologies have been developed to estimate the internal temperature of Li-ion and Na-ion batteries without recourse to temperature sensors.

WO2012/054473 discloses a method of using electrochemical impedance spectroscopy to determine a phase shift of a particular characteristic frequency f* associated with the movement of lithium ions through a solid electrolyte interface layer of a Li-ion cell, which is correlated with temperature in the normal operating temperature range.

S. S. Bhoir, G. Thenaisie, C. Brivio, M. Paolone, Li-ion cells internal temperature estimation using medium-frequency measurements impedance argument, Journal of Energy Storage 97 (2024) 112754 describes estimated the internal temperature of a battery by carrying out electrochemical impedance spectroscopy (EIS), and using the phase of the impedance of the battery at a characteristic frequency *f** related to the relaxation of the lithium-ions through the solid electrolyte interface (SEI) layer. This characteristic frequency was identified using a distribution of relaxation times (DRT) analysis of the EIS spectra, and the accuracy of the estimation method was validated under a certain set of normal operating conditions, with a correlation being established between the phase *φ* of the impedance Z and the internal temperature of the cell.

Hence, by carrying out EIS at the characteristic frequency f*, the phase of the impedance can be measured, from which the internal temperature of the cell can be estimated on the basis of said correlation, without recourse to temperature sensors integrated into, or packaged with, each cell.

However, the limits of the applicability of these methods were not tested, i.e. the validation did not involve the thermal or electrical abuse of the battery.

The aim of the invention is hence to at least partially overcome the above-mentioned limitations of the prior art.

### Disclosure of the Invention

More precisely, the invention relates to a method of detecting abuse of a rechargeable lithium-ion or sodium-ion cell, as defined in independent claim 1. This method comprises steps of:
- carrying out electrochemical impedance spectroscopy (EIS) measurements on said cell, at least at a characteristic frequency f* having a correlation with an internal temperature of said cell, this correlation holding for the normal operating conditions of the cell. The characteristic frequency f* may be predetermined for the type of cell, or may be empirically measured for the cell in question, as is generally known, and the EIS measurements may be carried out in charging, discharging or at steady state conditions;
- measuring an impedance *Z* of said cell at said characteristic frequency *f**, said impedance having a measured real component *Re*(*Z*)*ₘ*, a measured imaginary component *Im*(*Z*)*ₘ* and a measured phase angle *φ*(*Z*);
- estimating an estimated real component *Re*(*Z*)*ₑ* of said impedance Z on the basis of a predetermined correlation with said measured phase angle *φ*(*Z*) at said characteristic frequency *f**;
- detecting said abuse on the basis of a difference between said measured real component of said impedance *Re*(*Z*)*ₘ* at said characteristic frequency *f** and said estimated real component of said impedance *Re*(*Z*)*ₑ* at said characteristic frequency f* exceeding a predetermined threshold value.

By comparing the *Re*(*Z*)*ₘ* and *Re*(*Z*)*ₑ* values obtained by EIS at said characteristic frequency f*, any abuse of the cell which affects the relaxation of the lithium or sodium ions (depending on the cell type, lithium ions in the case of a Li-ion cell, and sodium ions in the case of a Na-ion cell) through the solid electrolyte interface (SEI) layer of the cell can be detected, without recourse to detecting overheating by means of a temperature sensor. This method is particularly reliable, since it essentially identifies when the correlation between *φ*(*Z*) and Re(Z) breaks down, which is due to physical and chemical processes occurring within the cell itself, which may be caused by various types of abuse such as thermal abuse, overcharging or mechanical abuse.

Advantageously, said abuse is detected by comparing said measured real component *Re*(*Z*)*ₘ* at said characteristic frequency *f** to said estimated real component *Re*(*Z*)*ₑ* at said characteristic frequency *f**, said abuse being detected when a said measured real component *Re*(*Z*)*ₘ* exceeds said estimated real component *Re*(*Z*)*ₑ* by said predetermined threshold value. Alternatively, said abuse is detected by comparing an anomaly value representing the difference *Re*(*Z*)*ₘ - Re*(*Z*)*ₑ* between said measured real component *Re*(*Z*)*ₘ* and said estimated real component *Re*(*Z*)*ₑ* at said characteristic frequency *f** exceeds said predetermined threshold value.

Advantageously, upon detection of said abuse, said cell is removed from service to prevent thermal runaway and breakdown.

Typically, said predetermined threshold value is between 0.01 mΩ and 200 mΩ, preferably between 0.01 mΩ and 0.25 mΩ 0.15 mΩ and 0.2 mΩ, the exact choice of threshold depending on the specific type, size etc. of cell.

This method may be carried out in a battery system comprising a cell and a controller arranged to control charging and/or discharging of said cell, said controller being adapted to carry out at least some, or indeed all, of the steps of the method as defined above.

### Brief description of the drawings

Further details of the invention will become apparent upon reading the detailed description, in reference to the appended figures which illustrate:
- Figure 1: a generic schematic representation of a system upon which the method of the invention may be practiced;

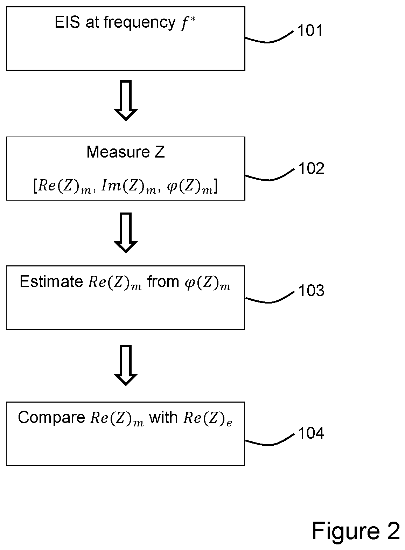

- Figure 2: a generic schematic flow diagram of the key steps of the method of the invention;
- Figure 3: an example of temperature and Re(Z) correlations with EIS phase at the characteristic frequency *f** of the a cell under test;
- Figure 4: an example of results obtained in an overcharging experiment;
- Figure 5: an example of results obtained in an overheating experiment.

### Embodiments of the Invention

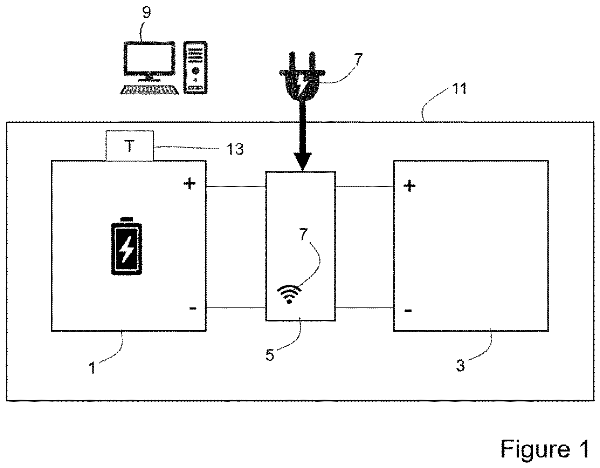

Figure 1 generically illustrates a battery system 11 comprised of at least one rechargeable lithium-ion or sodium-ion cell 1, the term "cell" being considered as synonymous with "battery", unless specifically stated. Cell 1 is arranged to power a device 3 of any convenient type, which may be a portable device (Smartphone, laptop computer, tablet, etc.), an electric vehicle, a hybrid vehicle, home or industrial appliances via a suitable interface, or similar. Cell 1 is associated with a controller 5, which is adapted to control the charging and discharging of the cell 1, charging taking place from an external power source 7 (grid electricity, solar panels, etc.) and/or by recuperation from the device 3, such as regenerative braking in the case of an electric or hybrid vehicle. Controller 5 may control any number of cells 1, may carry out part or the entirety of the method according to the invention, and may comprise, or be in communication with, a communications interface 7 adapted to communicate with at least one programmable computer 9, cloud computing solution or similar, in which case part of the method can be carried out remotely on said programmable computer, cloud computing solution or similar, if desired. An optional temperature sensor 13 may also be provided within the system 11 at a convenient location, whether internal or external to the cell 1, however integration of a temperature sensor 13 in or adjacent to each cell is typically not possible or desirable. When multiple cells 1 are present, temperature sensor 13 can, for instance, be packaged with the cells 1 in such a way that it measures a representative temperature.

Cell 1 itself comprises, as is generally known, a lithium-containing or sodium-containing anode, depending on the type of cell, a solid electrolyte, and a cathode of any convenient material, the electrolyte being in contact with both the anode and the cathode. The contact between the anode and the solid electrolyte forms a solid electrolyte interface (or interphase) layer. This is generally known in the literature and hence need not be discussed in detail here.

The method of the present invention comprises the following key steps, as illustrated schematically in figure 1:
Step 101: carrying out electrochemical impedance spectroscopy (EIS) on said cell 1 at a characteristic frequency *f** correlating with the internal temperature of the cell in its normal operating range. Characteristic frequency *f** may be predetermined for the type of cell, or may be measured for the cell itself using the methodology of Bhoir et al (op cit, hereby incorporated by reference in its entirety);
Step 102: measuring the impedance Z of said cell at said characteristic frequency *f**, said impedance having a measured real component *Re*(*Z*)*ₘ*, a measured imaginary component *Im*(*Z*)*ₘ* and a measured phase angle *φ*(*Z*);
Step 103: estimating an estimated real component *Re*(*Z*)*ₑ* of said impedance on the basis of a predetermined correlation with said measured phase angle *φ*(*Z*), this correlation having been empirically established for the type of cell 1;
Step 104: detecting said abuse on the basis of a difference between said measured real component *Re*(*Z*)*ₘ* of said impedance Z and said estimated real component *Re*(*Z*)*ₑ* of said impedance Z exceeding a predetermined threshold.

EIS, as it relates to rechargeable batteries, is well-known in the art, e.g. in Bhoir 2024 (cited above), and hence does not need to be described in detail. It may be carried out with or without a DC current offset, under charging, discharging or stable conditions. In essence, a current profile with a sinusoidal component at one or more frequencies is generated, either into or out of said battery, under the command of controller 5, while the voltage across the battery terminals is measured, or inversely, i.e. a voltage profile with a sinusoidal component at one or more frequencies is generated, while the current flowing into or out of the cell is measured. From this, an impedance measurement Z is derived, which is a complex number having a real component Re(Z), an imaginary component Im(Z), and a phase angle *φ*(*Z*). This can be carried out at various frequencies, of which the characteristic frequency *f** which has a correlation with internal cell temperature is concerned by the present invention.

The characteristic frequency *f** is related to the relaxation of the lithium or sodium ions (depending on the type of cell) through the solid electrolyte interface (SEI) layer of the cell, and can be determined individually for each individual cell, or may be predetermined based on laboratory experiments for the type of cell concerned, via any convenient methodology, including but not limited to that of Bhoir et al, 2024 (cited above).

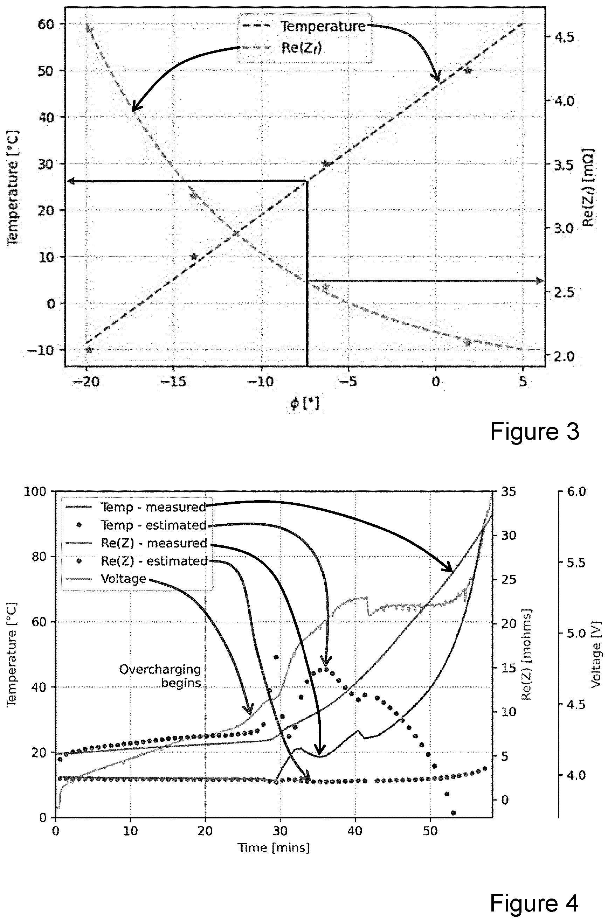

Figure 3 Illustrates a typical correlation between the phase *φ* of the impedance Z measured at the characteristic frequency f* (horizontal axis), internal cell temperature (left-hand vertical axis), and the real component Re(Z) of the impedance Z (right-hand vertical axis). As can be seen, the phase-to-temperature relationship is essentially linear, whereas the phase-to-Re(Z) relationship is a curve. These correlations hold for the acceptable internal temperature range of the cell.

The key to the present invention is the identification that comparing the measured *Re*(*Z*)*ₘ* to the estimated *Re*(*Z*)*ₑ* is indicative of the cell suffering from abuse, since when it is suffering abuse, the correlation of figure 3 breaks down, giving an incorrect estimate of not only cell temperature, but also *Re*(*Z*)*ₑ.*

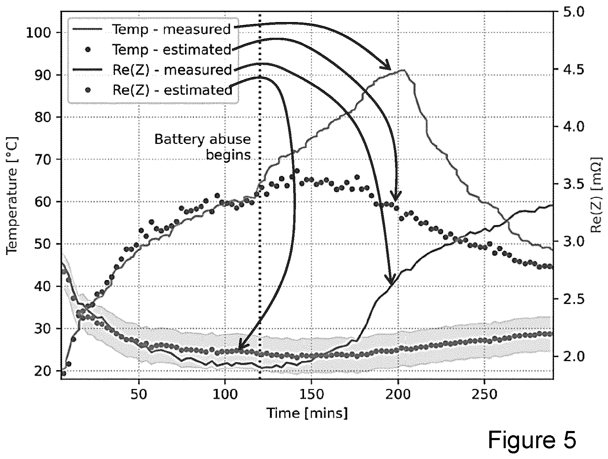

Figures 4 and 5 illustrate results of battery abuse experiments. The cell 1 concerned was a lithium-ion cell with a nominal capacity of 12 Ah, with graphite on the negative electrode and nickel manganese cobalt (NMC) on the positive electrode (Kokam, SLPB065070180). The batteries had a nominal voltage of 3.7 V and can be cycled between 2.7 and 4.2 V. According to the corresponding datasheet, the operating temperature is between 0 °C and 45 °C while charging and -20 °C and 55 °C during discharging. A temperature sensor 13 was placed in contact with the lateral face of the cell 1, and the cell 1 was sandwiched between aluminium pressure plates. In the case of the thermal abuse experiment reported in figure 5, a thermally-insulating layer was placed between the cell and the aluminium pressure plate on the side of the cell which was in contact with a first temperature sensor, and a heating element was arranged to heat the opposite aluminium pressure plate, with a second temperature sensor arranged on this side of the cell.

In each case, the characteristic frequency *f** was determined for the individual cell via the method of Bhoir et al, 2024 (mentioned above).

Figure 4 illustrates the results of an overcharging experiment carried out with the cell equipped with a temperature sensor as described above. The cell was charged using a current of 12 A while simultaneously performing EIS measurements from a frequency of 10 kHz to 1 Hz (5 points per decade). The measurements were taken with a DC offset of 1C (12 A for the cell used), simulating EIS measurements under load, and the experiment was performed until the cell underwent thermal runaway.

As can be seen at around the 25-30 minute point, the correlation between the measured temperature and estimated temperature based on the predetermined φ-temperature correlation broke down, despite the measured temperature still being well within allowable bounds. However, since the aim of the invention is to be able to detect battery abuse in the absence of a temperature sensor associated with each cell, it is more interesting to look at the measured Re(Z) and estimated Re(Z) values, which suddenly diverge at about the 29 minute mark, again while the internal temperature of the cell remains within the acceptable range. Indeed, this divergence starts several minutes before the 45°C upper limit of the working range of the cell has been reached, providing excellent early warning of an impending problem with the cell. In this case, this is caused by rapid gas formation within the cell, this rapid gas formation causing the *φ*(*Z*) *- Re*(*Z*) correlation to break down. Indeed, an advantage of the method of the invention is that the breakdown of the *φ*(*Z*) *-* Re(Z) correlation is not arbitrary, but is related to chemical and physical changes in the cell itself, so is adaptable to many different cells without requiring experimentation to find the point at which the correlation no longer holds: it no longer holds because of phenomena occurring in the cell itself.

By setting a threshold for this difference, e.g. 0.15 mΩ or any other convenient threshold (which may lie between extreme bounds of 0.01 mΩ and 200 mΩ, depending on the exact cell in question), this abuse can be detected in a timely fashion without recourse to a temperature sensor 13. Alternately, an anomaly value *Re*(*Z*)*ₑ* - *Re*(*Z*)*ₘ* corresponding to the difference between measured and estimated *Re*(*Z*) values can be calculated, with a threshold value applied to the magnitude of this anomaly, in order to detect abuse.

Figure 5 reports results from a thermal abuse experiment carried out on the cell as described above, by heating the cell from the outside with the heating element as described above. The shaded area around the *Re*(*Z*)*ₑ* estimated trace illustrates an example of a threshold (±0.15 mΩ in this case, but any suitable arbitrary threshold can be used) applied to said estimated real component of impedance such that, if the measured real component of impedance *Re*(*Z*)*ₘ* diverges from the estimated *Re*(*Z*)*ₑ* value by more than this difference threshold, abuse of the cell is detected.

As can be seen from figure 5, this threshold is exceeded at about the 176 minute mark, by which time the internal temperature of the cell is estimated at about 65 °C, but its real temperature is over 80°C. In such a case, the cell can be removed from operation and isolated before breakdown and a potential fire hazard occurs. Alternately, an anomaly value *Re*(*Z*)*ₑ* - *Re*(*Z*)*ₘ* corresponding to the difference between measured and estimated *Re*(*Z*) values can be calculated, with a threshold value applied to the magnitude of this anomaly to detect abuse.

Naturally, the estimated and measured temperature curves diverge before the estimated and measured *Re*(*Z*) curves do, which is to be expected in a thermal abuse experiment. However, in practice, no accurate measured temperature is available to be exploited, or no temperature data measurements are available at all, due to the absence of a temperature sensor on each cell. This graph hence proves the effectiveness and exploitability of divergence between the measured and estimated Re(Z) values.

In the thermal runaway case of figure 5, the breakdown of the *φ*(*Z*) *- Re*(*Z*) correlation is a result of the breakdown of the SEI layer, and while there is a lag between this starting to occur at about 60°C and the divergence of the Re(Z) curves, this is acceptable since it happens sufficiently early to be able to remove the cell in question from operation before a fire hazard occurs.

It should be noted that the reduction in the measured temperature after 200 minutes is caused by no longer externally heating the cell and allowing it to cool, however this is not of relevance to the present invention and can be ignored.

Furthermore, it can be expected that the method of the present invention can also detect any other kind of abuse which impacts the SEI layer, such as physical abuse causing physical damage to the battery, since in any case the real part of the measured impedance *Re*(*Z*)*ₘ* increases many fold due to gas formation, independently of the kind of abuse to which the cell has been subjected. This enables identification of abuse and removal of the cell 1 from service.

Although the invention has been described in reference to specific embodiments, further variations are possible without departing from the scope of the invention as defined in the appended claims.

## Claims

1. Method of detecting abuse of a rechargeable lithium-ion or sodium-ion cell (1), comprising steps of:
- carrying out electrochemical impedance spectroscopy measurements on said cell (1), at least at a characteristic frequency *f** having a correlation with an internal temperature of said cell (1);
- measuring an impedance *Z* of said cell (1) at said characteristic frequency *f**, said impedance having a measured real component *Re*(*Z*)*ₘ*, a measured imaginary component *Im*(*Z*)*ₘ* and a measured phase angle *φ*(*Z*);
- estimating an estimated real component *Re*(*Z*)*ₑ* of said impedance *Z* on the basis of a predetermined correlation with said measured phase angle *φ*(*Z*);
- detecting said abuse on the basis of a difference between said measured real component of said impedance *Re*(*Z*)*ₘ* and said estimated real component of said impedance *Re*(*Z*)*ₑ* exceeding a predetermined threshold value.

2. Method according to the preceding claim, wherein said abuse is detected by comparing said measured real component *Re*(*Z*)*ₘ* to said estimated real component *Re*(*Z*)*ₑ,* said abuse being detected when a said measured real component *Re*(*Z*)*ₘ* exceeds said estimated real component *Re*(*Z*)*ₑ* by said predetermined threshold value.

3. Method according to claim 1, wherein said abuse is detected by comparing an anomaly value representing the difference *Re*(*Z*)*ₘ - Re*(*Z*)*ₑ* between said measured real component *Re*(*Z*)*ₘ* and said estimated real component *Re*(*Z*)*ₑ* exceeds said predetermined threshold value.

4. Method according to any preceding claim, wherein said abuse is at least one of overheating or overcharging.

5. Method according to any preceding claim, wherein, upon detection of said abuse, said cell (1) is removed from service.

6. Method according to any preceding claim, wherein said predetermined threshold value is between 0.01 mΩ and 200 mΩ, preferably between 0.1 mΩ and 0.25 mΩ, further preferably between 0.15 mΩ and 0.2 mΩ.

7. Battery system (11) comprising a cell (1) and a controller (5) arranged to control charging and/or discharging of said cell (1), wherein said controller (5) is adapted to carry out at least some of the steps of the method of any preceding claim.

8. Battery system (11) according to claim 7, wherein said controller (5) is adapted to carry out the entirety of the steps of said method.
